# EUROPÄISCHE PATENTANMELDUNG

(11) **EP 3 410 483 A1**
(43) Veröffentlichungstag der Anmeldung: **05.12.2018**
(21) Anmeldenummer: 18175313.8
(22) Anmeldetag: 31.05.2018
(51) Int. Cl.: H01L 25/18, H01L 25/065, H01L 23/31, H01L 23/498, H01L 21/56, H01L 21/98, H01L 25/10

(54) **VERFAHREN ZUR HERSTELLUNG EINES PACKAGES UND PACKAGE**

(30) Priorität: 31.05.2017 DE 102017209249
(71) Anmelder: FRAUNHOFER-GESELLSCHAFT zur Förderung der angewandten Forschung e.V., 80686 München (DE)
(72) Erfinder: Böttcher, Mathias, 01109 Dresden (DE); Wolf, M. Jürgen, 10439 Berlin (DE)
(74) Vertreter: Pfenning, Meinig & Partner mbB

(57) **Zusammenfassung**

Die Anmeldung betrifft ein Verfahren zur Herstellung eines Packages (1). Bei dem vorgeschlagenen Verfahren werden zunächst eine erste Bauteilanordnung (2) und eine zweite Bauteilanordnung (13) bereitgestellt. Die erste Bauteilanordnung (2) und die zweite Bauteilanordnung (13) weisen jeweils eine flächige Umverdrahtungslage (6, 16) und jeweils zumindest eine auf einer in Richtung einer Vorderseite der Bauteilanordnung (2, 13) weisenden Seite der Umverdrahtungslage (6, 16) angeordnete elektronische Komponente auf (11, 11', 17). Die Umverdrahtungslage (6, 16) weist elektrisch isolierendes Material (8) und Leiterbahnen (9, 9') auf. Zumindest eine der Leiterbahnen (9, 9') der Umverdrahtungslage (6, 16) ist mit der elektronischen Komponente (11, 11', 17) elektrisch leitend verbunden. In einem weiteren Schritt werden die Bauteilanordnungen (2, 13) derart zueinander angeordnet, dass die Vorderseiten der Bauteilanordnungen (2, 13) einander zugewandt sind und dass ein durch die Bauteilanordnungen (2, 13) begrenzter Zwischenraum (21) zwischen den Umverdrahtungslagen (6, 16) ausgebildet wird. In typischen Ausführungen wird ein Füllmaterial in den Zwischenraum eingebracht.

## Beschreibung

Die vorliegende Anmeldung liegt auf dem Gebiet der Mikroelektronik und insbesondere auf dem Gebiet gehäuster elektronischer Bauelemente, sogenannter Packages oder System-in-Packages. Die Anmeldung betrifft ein Verfahren zur Herstellung eines Packages (bzw. eines gehäusten elektronischen Bauelements) nach dem Oberbegriff des Anspruchs 1. Darüber hinaus betrifft die Anmeldung ein Package.

Aus dem Stand der Technik sind unterschiedliche Gehäusebauformen für elektronische Komponenten (Chips) bekannt. Beispielsweise können sogenannte Wafer-Level-Packages integrierte Schaltungen oder Sensoren aufweisen, die in der Regel zweidimensional in einem Gehäuse angeordnet sind. Anschlüsse werden hierbei typischerweise auf einer Seite des Gehäuses aus diesem herausgeführt. In verbreiteten Anwendungen werden auf diese Weise hergestellte elektronische Bauelemente in nachfolgenden Montageprozessen nebeneinander angeordnet und gegebenenfalls elektrisch miteinander verbunden.

Bei sogenannten Fan-Out-Wafer-Level-Packages, wie zum Beispiel in der eWLB-Technologie ("embedded Wafer Level Ball Grid Array") ist es vorgesehen, dass vereinzelte Chips, die auf einer Vorderseite Kontakte, beispielsweise AI-Kontakte, aufweisen, mit ihrer Vorderseite ("face down") auf eine Folie geklebt werden. Anschließend können die Chips mit einer Moldmasse (z.B. Epoxyd) umhüllt werden. Durch den Umhüllungsprozess entsteht ein neues Substrat, welches in nachfolgenden Schritten von der Folie entfernt wird. Anschließend kann durch das Aufbringen von elektrisch Lagen und Leiterbahnen auf die teilweise durch die zunächst freiliegenden Kontakte der Chips gebildete Seite des Substrates eine elektrische Verbindungslage (Umverdrahtungslage) hergestellt werden. Anschließend können auf freigestellten Kontakpads das die Chips umfassende Substrat und die Umverdrahtungslage mit Lotbällen bestückt werden.

Es ist eine Aufgabe der vorliegenden Anmeldung ein Verfahren zur Herstellung eines Packages vorzuschlagen. Insbesondere ist es eine Aufgabe der vorliegenden Anmeldung ein Verfahren zur Herstellung eines Packages vorzuschlagen, welches eine erhöhte Integrationsdichte von elektronischen Komponenten, einen höheren Formfaktor sowie verbesserte thermische Eigenschaften ermöglicht. Darüber hinaus ist es eine Aufgabe der vorliegenden Anmeldung ein entsprechend verbessertes Package vorzuschlagen.

Gelöst werden diese Aufgaben durch ein Verfahren mit den Merkmalen des Anspruchs 1 sowie durch ein Package mit den Merkmalen eines weiteren unabhängigen Anspruchs. Vorteilhafte Weiterbildungen ergeben sich mit den Merkmalen der abhängigen Ansprüche und der Ausführungsbeispiele.

Bei dem vorgeschlagenen Verfahren zur Herstellung eines Packages (bzw. eines elektronischen Bauelements, beispielsweise ein System-In-Package), das mehrere elektronische Komponenten (insbesondere Chips umfassend) aufweist, werden zunächst eine erste Bauteilanordnung und eine zweite Bauteilanordnung bereitgestellt. Die erste Bauteilanordnung und die zweite Bauteilanordnung weisen jeweils eine flächige Umverdrahtungslage und jeweils zumindest eine auf einer in Richtung einer Vorderseite der Bauteilanordnung weisenden Seite der Umverdrahtungslage angeordnete elektronische Komponente auf. Die Umverdrahtungslage weist elektrisch isolierendes Material (insbesondere ein Dielektrikum) und Leiterbahnen auf. Zumindest eine der Leiterbahnen der Umverdrahtungslage ist mit der elektronischen Komponente elektrisch leitend verbunden. In einem weiteren Schritt werden die Bauteilanordnungen derart zueinander angeordnet, dass die Vorderseiten der Bauteilanordnungen einander zugewandt sind und dass ein durch die Bauteilanordnungen begrenzter Zwischenraum zwischen den Umverdrahtungslagen ausgebildet wird.

In typischen Ausführungen wird ein Füllmaterial in den Zwischenraum eingebracht. Beispielsweise kann hierbei das Füllmaterial vor dem Anordnen der Bauteilanordnungen zueinander auf einer der Bauteilanordnungen angeordnet werden oder nach dem Anordnen der Bauteilanordnungen zueinander in dem Zwischenraum angeordnet werden. Das Füllmaterial liegt hierbei typischerweise zumindest einer der Bauteilanordnungen an. Das Füllmaterial weist in der Regel eine gewisse mechanische Stabilität auf, so dass dieses dem Package eine erhöhte mechanische Stabilität verleiht.

Das Füllmaterial kann beispielsweise eine Mold-Masse beziehungsweise eine Vergussmasse sein. Der Zwischenraum zwischen der ersten Bauteilanordnung und der zweiten Bauteilanordnung kann beispielsweise nach oder vor dem Anordnen der Bauteilanordnungen zueinander mit der Vergussmasse ausgefüllt, insbesondere vergossen oder vermoldet, werden.

Ein auf diese Weise hergestelltes Package (bzw. elektronisches Bauelement oder System-In-Package) weist die erste Bauteilanordnung und die zweite Bauteilanordnung auf. Die erste Bauteilanordnung und die zweite Bauteilanordnung weisen jeweils die flächige Umverdrahtungslage und jeweils die zumindest eine auf der in Richtung der Vorderseite der Bauteilanordnung weisenden Seite der Umverdrahtungslage angeordnete elektronische Komponente auf. Die Umverdrahtungslage weist das elektrisch isolierende Material und Leiterbahnen auf. Außerdem ist zumindest eine der Leiterbahnen der Umverdrahtungslage mit der elektronischen Komponente elektrisch leitend verbunden. Die Bauteilanordnungen sind derart zueinander angeordnet, dass die Vorderseiten der Bauteilanordnungen einander zugewandt sind und dass der durch die Bauteilanordnungen begrenzte Zwischenraum zwischen den Umverdrahtungslagen ausgebildet ist. In den Zwischenraum zwischen der ersten und der zweiten Bauteilanordnung kann das Füllmaterial eingebracht sein. Beispielsweise kann der Zwischenraum zwischen der ersten Bauteilanordnung und der zweiten Bauteilanordnung mit der Vergussmasse vergossen sein.

Das vorgeschlagene Verfahren eignet sich für eine Vielzahl unterschiedlicher elektronischer Komponenten. Insbesondere ist das Verfahren für die System-in-Package-Technologie geeignet, wobei das wie beschrieben hergestellte Package eine Vielzahl unterschiedlicher elektronischer Komponenten umfassen kann. Die elektronischen Komponenten sind typischerweise mikroelektronische Komponenten. Die Komponenten können beispielsweise analoge oder digitale Schaltungen (insbesondere Chips) enthalten und/oder aktive oder passive Komponenten sein. Insbesondere können die elektronischen Komponenten Mikrosysteme, wie beispielsweise MEMS, und/oder Halbleiterchips und/oder integrierte Schaltungen umfassen.

Typischerweise werden die Bauteilanordnungen so zueinander angeordnet, dass ein Bereich der Vorderseite der zweiten Bauteilanordnung auf einem Bereich der Vorderseite der ersten Bauteilanordnung zu liegen kommt. Der Zwischenraum wird in typischen Ausführungen nach dem Anordnen der Bauteilanordnungen und typischerweise unter Beaufschlagung mit einem erhöhten Druck und/oder unter Erhitzen verfüllt beziehungsweise vergossen. Dabei können die Bauteilanordnungen miteinander verbunden werden. Hierbei ist der Zwischenraum typischerweise seitlich zugänglich und wird auch von den Seiten her verfüllt. In möglichen Ausführungen füllt das Füllmaterial beziehungsweise die Vergussmasse den Zwischenraum nach dem Einbringen beziehungsweise Vergießen nahezu vollständig aus oder zumindest zu 50 Vol.-%, insbesondere zumindest zu 80 Vol.-%. Typischerweise wird das Füllmaterial beziehungsweise die Vergussmasse anschließend ausgehärtet. Das Aushärten muss allerdings nicht zwingend vorgesehen sein. Durch das Füllmaterial wird um die elektronischen Komponenten ein mechanisch stabiles Gehäuse ausgebildet.

Es kann in einigen Ausführungen vorgesehen sein, dass das Füllmaterial in Bereichen des elektronischen Bauteils bewusst eingebrachte Aussparungen aufweist, so dass der Zwischenraum nicht vollständig mit dem Füllmaterial ausgefüllt ist. Dies kann erreicht werden, indem Barriereelemente vorgesehen sind, die einen Teilbereich des Zwischenraums umschließen. Die Barriereelemente können sich beispielsweise zwischen der ersten und der zweiten Bauteilanordnung erstrecken. Die Barriereelemente bilden typischerweise eine Barriere und/oder sind undurchlässig für das Füllmaterial, so dass nach dem Einbringen des Füllmaterials in den Zwischenraum in dem Teilbereich des Zwischenraums eine Aussparung des Füllmaterials ausgebildet wird. Besonders wenn eine in dem Teilbereich angeordnete elektronischen Komponente der ersten oder der zweiten Bauteilanordnung angeordnet ist, deren Funktionalität durch ein Umschließen mit dem Füllmaterial beeinträchtigt werden würde, eignet sich das Erzeugen der Aussparung. Diese elektronische Komponente kann beispielsweise ein Sensor sein. Die Barriereelemente können beispielsweise wie weiter unten beschriebene Durchkontaktierungselemente ausgebildet sein.

Das Füllmaterial beziehungsweise die Vergussmasse ist in typischen Ausführungen elektrisch isolierend. Die Vergussmasse kann einen Kunststoff enthalten. Hierbei eignen sich insbesondere Moldmaterialien oder Epoxidmaterialien.

Indem die Bauteilanordnungen wie beschrieben zueinander angeordnet werden, lassen sich durch das vorgeschlagene Verfahren auf vergleichsweise einfache und kosteneffiziente Weise gehäuste Packages mit einer großen Funktionalität auf einer kleinen Fläche, insbesondere mit hoher Integrationsdichte (besserer Formfaktor), herstellen. Zudem erlaubt das vorgeschlagene Verfahren eine besonders kompakte, insbesondere eine flache, Bauform. Eine Höhe des Packages, insbesondere ein senkrechter Abstand zwischen Rückseiten der Umverdrahtungslagen der ersten und der zweiten Bauteilanordnung, kann in einigen Ausführungen höchstens 3 mm, insbesondere höchstens 1 mm, und/oder in einigen Ausführungen mindestens 100 µm betragen.

In typischen Ausführungen sind die Umverdrahtungslagen des vorgeschlagenen elektronischen Bauteils nach dem Anordnen der Bauteilanordnungen zueinander jeweils von ihrer Rückseite zugänglich, was hinsichtlich einer geometrischen Anordnung relativ zu weiteren elektronischen Bauelementen oder Packages eine große Gestaltungsfreiheit zulässt. Jede der Umverdrahtungslagen oder zumindest eine der Umverdrahtungslagen kann zumindest eine durchgehende elektrische Verbindung zwischen einer Oberseite und einer Unterseite der Umverdrahtungslage aufweisen. Auf diese Weise können elektrische Verbindungen von elektronischen Komponenten auf eine Außenseite des Packages geführt werden. Dadurch können mehrere Packages in einfacher Weise einer gewünschten funktionalen Anwendung entsprechend dreidimensional aufeinandergestapelt und elektrisch miteinander verbunden werden.

Das vorgeschlagene Verfahren erlaubt auch eine große Gestaltungsfreiheit hinsichtlich einer Anordnung der elektronischen Komponenten in dem Package. In einigen Ausführungen sind die elektronischen Komponenten derart zueinander angeordnet, dass Wärmeverformungen des Packages, die durch unterschiedliche Wärmeausdehnungskoeffizienten der elektronischen Komponenten und des Füllmaterials, insbesondere der Vergussmasse, hervorgerufen werden können, teilweise oder vollständig kompensiert werden. Insbesondere durch eine symmetrische oder quasi-symmetrische Anordnung der elektronischen Komponenten kann eine ungewollte Biegung des Packages vermieden werden.

In typischen Ausführungen umfasst das Bereitstellen der ersten Bauteilanordnung und/oder der zweiten Bauteilanordnung ein Bereitstellen eines Substratträgers. Anschließend kann auf dem Substratträger die Umverdrahtungslage hergestellt werden, wobei die Umverdrahtungslage das elektrisch isolierende Material und die Leiterbahnen aufweist. In einem weiteren Schritt kann die zumindest eine elektronische Komponente auf der Umverdrahtungslage angeordnet werden. Ferner kann die elektronische Komponente mit zumindest einer der Leiterbahnen elektrisch leitfähig verbunden werden.

Es kann vorgesehen sein, dass vor dem Herstellen der Umverdrahtungslage eine Ablöseschicht ("Release"-Schicht) auf dem Substratträger angeordnet wird, wobei anschließend die Umverdrahtungslage auf der Ablöseschicht angeordnet oder hergestellt wird. Die Ablöseschicht kann beispielsweise mittels eines Spin-On-Prozesses auf den Substratträger aufgebracht werden. Die Ablöseschicht verhindert typischerweise eine direkte stoffschlüssige Verbindung zwischen der Umverdrahtungslage und dem Substratträger, so dass der Substratträger in späteren Herstellungsschritten auf einfache Weise von dem Package beziehungsweise von weiteren Bestandteilen des Packages abgelöst werden kann.

Bei der Umverdrahtungslage handelt es sich typischerweise um eine sogenannte "Redistribution Layer (RDL)", für deren Herstellung an sich bekannte Verfahren verwendet werden können. Zur Herstellung der Umverdrahtungslage können beispielsweise an sich bekannte Verfahren aus der Dünnschichttechnologie zum Einsatz kommen. In typischen Ausführungen umfasst die Umverdrahtungslage als Leiterbahnen Metallisierungen, die insbesondere mehrschichtig angeordnet sein können und die durch das elektrisch isolierende Material, das typischerweise einen Kunststoff enthält, voneinander elektrisch isolierend getrennt werden. Leiterbahnen, insbesondere Leiterbahnen unterschiedlicher Bauteilanordnungen, können an geeigneten Stellen über sogenannte Vias miteinander verbunden sein.

Wenn die elektronischen Komponenten zunächst auf den Umverdrahtungslagen angeordnet und mit diesen verbunden werden und erst anschließend vergossen werden, wird erreicht, dass die Komponenten auch während des Vergießens und nach dem Vergießen ihre Positionierung beibehalten. Eventuell durch das Vergießen oder Umhüllen entstehende Verschiebungen der elektronischen Komponenten können somit verhindert werden. Dadurch können zur Erhöhung der Integrationsdichte auch hochpolige elektronische Komponenten mit kleinen Kontaktflächen und kleinen Kontaktabständen (Pitch) Verwendung finden und zuverlässig mit auf der Umverdrahtungslage vorgesehenen Verbindungsstellen verbunden werden. Dies erlaubt insbesondere eine Verwendung von Fine-Pitch-Komponenten (ICs) als elektronische Komponenten. Zudem erlaubt das vorgeschlagene Verfahren beispielsweise, dass die elektronischen Komponenten über eine Flip-Chip-Montage oder unter Verwendung von Drahtbonds elektrisch leitend mit der Umverdrahtungslage verbunden werden. Indem die elektronischen Komponenten typischerweise vor dem Einbringen des Füllmaterials oder dem Vergießen mit der Umverdrahtungslage verbunden sind, können die Komponenten oder gewählte Anordnungen von Komponenten auch schon vor Fertigstellung des Packages elektrisch getestet und gegebenenfalls ausgetauscht werden.

Es kann vorgesehen sein, dass die erste Bauteilanordnung auf der in Richtung der Vorderseite der Bauteilanordnung weisenden Seite der Umverdrahtungslage zumindest ein mit zumindest einer der Leiterbahnen elektrisch leitfähig verbundenes Durchkontaktierungselement aufweist. Das zumindest eine
Durchkontaktierungselement kann mit zumindest einer der Leiterbahnen der Umverdrahtungslage der zweiten Bauteilanordnung nach dem Anordnen oder während des Anordnens der Bauteilanordnungen zueinander elektrisch leitfähig verbunden werden. Das Durchkontaktierungselement bzw. die Durchkontaktierungselemente ist bzw. sind während des Einbringens des Füllmaterials in den Zwischenraum typischerweise fest mit einer der Bauteilanordnungen verbunden.

Es kann darüber hinaus vorgesehen sein, dass die zweite Bauteilanordnung auch zumindest ein mit zumindest einer der Leiterbahnen der Umverdrahtungslage der zweiten Bauteilanordnung elektrisch leitfähig verbundenes Durchkontaktierungselement aufweist. Die Bauteilanordnungen können hierbei derart zueinander angeordnet werden, dass ein Bereich des Durchkontaktierungselements der ersten Bauteilanordnung auf einem Bereich des Durchkontaktierungselements der zweiten Bauteilanordnung zu liegen kommt. Beim und/oder zum elektrisch leitfähigen Verbinden des Durchkontaktierungselements der ersten Bauteilanordnung mit der Leiterbahn der Umverdrahtungslage der zweiten Bauteilanordnung kann das Durchkontaktierungselement der ersten Bauteilanordnung mit dem Durchkontaktierungselement der zweiten Bauteilanordnung elektrisch leitfähig verbunden werden.

Durch das Durchkontaktierungselement beziehungsweise die Durchkontaktierungselemente können die Umverdrahtungslagen auf besonders einfache Weise elektrisch miteinander verbunden werden. Hierfür ist nach der Herstellung des Packages kein gesonderter Schritt notwendig. Zudem können die Durchkontaktierungselemente nach dem beschriebenen Verfahren sehr präzise relativ zu den elektronischen Komponenten und den Umverdrahtungslagen positioniert und daher schmal ausgeführt werden. Die Durchkontaktierungselemente können beispielsweise in engen Rastern angeordnet werden.

Das Durchkontaktierungselement der ersten und/oder der zweiten Bauteilanordnung kann beispielsweise zumindest bereichsweise als Micropillar, insbesondere als Copper-Pillar-Bump, als Lotkugel oder als anderes geeignetes Durchkontaktierungselement, ausgebildet sein. Die Durchkontaktierungselemente können beispielsweise durch Löten elektrisch verbunden werden. Nach dem Anordnen der Bauteilanordnungen zueinander können diese auch mittels Substrat-zu-Substrat-Bonden, zum Beispiel mittels Wafer-Bonden, miteinander verbunden werden.

Es kann in einigen Ausführungen vorgesehen sein, dass durch das Anordnen der Bauteilanordnungen eine endgültige Höhe des Zwischenraums des Packages festgelegt wird. Beispielsweise kann es in einigen Ausführungen auch vorgesehen sein, dass das Durchkontaktierungselement der ersten Bauteilanordnung und das Durchkontaktierungselement der zweiten Bauteilanordnung bzw. die Barriereelemente zumindest bereichsweise, insbesondere vollständig, fest und/oder steif sind. Insbesondere kann es vorgesehen sein, dass das Durchkontaktierungselement der ersten Bauteilanordnung und das Durchkontaktierungselement der zweiten Bauteilanordnung bzw. die Barriereelemente beim Anordnen der Bauteilanordnungen zueinander vollständig oder zumindest bereichsweise fest und/oder steif sind, beispielsweise in einer Ausführung als Micropillar. Dadurch kann erreicht werden, dass eine gewünschte und insbesondere die endgültige Höhe des Zwischenraums nach dem Anordnen der Bauteilanordnungen durch ein Aufliegen der Durchkontaktierungselemente bzw. durch ein Anliegen der Barriereelemente festgelegt wird. Beispielsweise können die Durchkontaktierungselemente bzw. die Barriereelemente derart steif bzw. fest ausgebildet sein, dass durch diese die endgültige Höhe des Zwischrenraums festlegbar ist oder insbesondere festgelegt wird.

Beispielsweise kann es vorgesehen sein, dass nach dem Anordnen der Bauteilanordnungen zueinander kein externer Halter vorgesehen ist, der nicht Teil des hergestellten Packages ist und der die Bauteilanordnungen in solch einer Anordnung zueinander hält, dass der Zwischenraum eine definierte Höhe aufweist. Auf den Halter kann beispielsweise dadurch erreicht werden, dass die Durchkontaktierungselemente bzw. die Barriereelemente als Abstandshalter dienen, die die gewünschte und insbesondere die endgültige Höhe des Zwischenraums nach dem Anordnen der Bauteilanordnungen zueinander festlegen.

In manchen Ausführungen kommt beim Anordnen der Bauteilanordnungen zueinander eine Vorderseite der elektronischen Komponente der ersten Bauteilanordnung an der zweite Bauteilanordnung zum Anliegen. Es kann zusätzlich oder alternativ vorgesehen sein, dass beim Anordnen der Bauteilanordnungen zueinander eine Vorderseite der elektronischen Komponente der zweiten Bauteilanordnung an der ersten Bauteilanordnung zum Anliegen kommt. Insbesondere kann die Vorderseite der elektronischen Komponente der ersten oder der zweiten Bauteilanordnung hierbei an einer Vorderseite der Umverdrahtungslage der zweiten beziehungsweise der ersten Bauteilanordnung zum Anliegen kommen. Typischerweise kommt die elektronische Komponente an einem wärmeleitenden Bestandteil der Bauteilanordnung zum Anliegen. Dadurch kann von der elektronischen Komponente im Betrieb erzeugte Wärme effizient in Richtung der ersten und in Richtung der zweiten Umverdrahtungslage abgeführt werden und somit eine Temperaturstabilität des Packages erhöht werden. Insbesondere wenn die elektronische Komponente an der Umverdrahtungslage anliegt, kann ein besonders effizienter Wäreabtransport von der elektronischen Komponente in die daran anliegende Umverdrahtungslage gewährleistet werden.

Die erste Bauteilanordnung und die zweite Bauteilanordnung können nach dem vorgeschlagenen Verfahren besonders platzsparend angeordnet werden. Es kann beispielsweise vorgesehen sein, dass die erste Bauteilanordnung und die zweite Bauteilanordnung verschachtelt angeordnet werden. Die erste Bauteilanordnung und die zweite Bauteilanordnung können derart zueinander angeordnet werden, dass eine parallel zur Umverdrahtungslage der ersten und/oder der zweiten Bauteilanordnung verlaufende Ebene sowohl die elektronische Komponente der ersten Bauteilanordnung als auch die elektronische Komponente der zweiten Bauteilanordnung schneidet. Auf diese Weise wird erreicht, dass das hergestellte Package besonders flach ist.

Es kann vorgesehen sein, dass elektrisch mit zumindest einer der Leiterbahnen verbundene Lötkontakte, beispielsweise Lotbälle, auf der Rückseite der Umverdrahtungslage der ersten und/oder der zweiten Bauteilanordnung, d.h. auf einer von der Vorderseite der ersten beziehungsweise der zweiten Bauteilanordnung abgewandten Seite der Umverdrahtungslage der ersten beziehungsweise der zweiten Bauteilanordnung, hergestellt werden. Auf diese Weise kann beispielsweise eine einfache Montage des Packages auf einer Leiterplatte ermöglicht werden. Hierbei kann es gegebenenfalls erforderlich sein, dass der Substratträger zunächst von der Rückseite der entsprechenden Umverdrahtungslage entfernt wird.

Der Substratträger kann in einigen Ausführungen als Bestandteil des fertig hergestellten Packages mit der Rückseite der entsprechenden Umverdrahtungslage verbunden bleiben. Der Substratträger kann beispielsweise passive elektronische Komponenten umfassen und/oder als optischer Filter ausgebildet sein. Es kann auch vorgesehen sein, dass jeweils ein Substratträger sowohl mit der Rückseite der Umverdrahtungslage der ersten Bauteilanordnung als auch mit der Rückseite der Umverdrahtungslage der zweiten Bauteilanordnung verbunden bleibt.

Es kann in einigen Ausführungen zumindest eine Durchkontaktierung durch einen mit der Rückseite der Umverdrahtungslage der ersten und/oder der zweiten Bauteilanordnung verbundenen Substratträger hergestellt werden. Diese Durchkontaktierung kann elektrisch mit zumindest einer der Leiterbahnen der ersten beziehungsweise der zweiten Bauteilanordnung verbunden werden. Die Durchkontaktierung durch den Substratträger kann beispielsweise als Through-Silicon-Via oder als Through-Glass-Via ausgeführt sein.

Typischerweise wird eine, beispielsweise nach dem Vergießen des Zwischenraums entstehende, die erste Bauteilanordnung, die zweite Bauteilanordnung und das Füllmaterial umfassende Struktur vereinzelt. Dadurch kann gegebenenfalls eine Anzahl benötigter Herstellungsschritte reduziert werden, da etwa unter Durchführung eines einzigen Vergussschritts eine Vielzahl von vereinzelten Packages hergestellt werden kann.

Ein nach dem vorgeschlagenen Verfahren hergestelltes Package ist stapelbar, wobei durch ein Erzeugen elektrischer Verbindungen zwischen verschiedenen Ebenen eines Stapels eine hohe Funktionalität auf engem Raum erzielt werden kann. Beispielsweise durch ein Aufeinanderschichten der beschriebenen Strukturen kann eine besonders hohe Integrationsdichte erzeugt werden.

Das Package kann in einigen Ausführungen eine dritte Bauteilanordnung aufweisen. Die dritte Bauteilanordnung kann eine flächige Umverdrahtungslage und zumindest eine auf einer in Richtung einer Vorderseite der dritten Bauteilanordnung weisenden Seite der Umverdrahtungslage angeordnete elektronische Komponente aufweisen. Die Umverdrahtungslage kann elektrisch isolierendes Material und Leiterbahnen aufweisen und zumindest eine der Leiterbahnen der Umverdrahtungslage kann mit der elektronischen Komponente der dritten Bauteilanordnung elektrisch leitend verbunden sein. Die dritte Bauteilanordnung kann hierbei derart angeordnet sein, dass die Vorderseite der dritten Bauteilanordnung einer Rückseite der ersten Bauteilanordnung zugewandt ist und dass ein zwischen der dritten Bauteilanordnung und der ersten Bauteilanordnung ausgebildeter und teilweise durch die dritte Bauteilanordnung begrenzter zweiter Zwischenraum ausgebildet ist. Dieser zweite Zwischenraum kann ein Füllmaterial enthalten oder mit einer Vergussmasse vergossen sein.

In einer möglichen Ausführung kann hierbei eine vierte Bauteilanordnung vorgesehen sein. Die vierte Bauteilanordnung kann eine flächige Umverdrahtungslage und zumindest eine auf einer in Richtung einer Vorderseite der vierten Bauteilanordnung weisenden Seite der Umverdrahtungslage angeordnete elektronische Komponente aufweisen. Die Umverdrahtungslage weist typischerweise elektrisch isolierendes Material und Leiterbahnen auf. Zumindest eine der Leiterbahnen der Umverdrahtungslage kann mit der elektronischen Komponente der vierten Bauteilanordnung elektrisch leitend verbunden sein. Die vierte Bauteilanordnung kann hierbei derart zwischen der ersten Bauteilanordnung und der dritten Bauteilanordnung angeordnet sein, dass die Vorderseite der vierten Bauteilanordnung der dritten Bauteilanordnung zugewandt und von der ersten Bauteilanordnung abgewandt ist. Zumindest eine der Leiterbahnen der vierten Bauteilanordnung kann mit zumindest einer der Leiterbahnen der ersten Bauteilanordnung elektrisch leitend verbunden sein. Hierbei wird der zweite Zwischenraum in der Regel teilweise durch die vierte Bauteilanordnung begrenzt werden.

In einer weiteren möglichen Ausführung kann anstatt der vierten Bauteilanordnung eine weitere elektronische Komponente vorgesehen sein. Die weitere elektronische Komponente kann auf der Rückseite der ersten Bauteilanordnung angeordnet sein und mit zumindest einer der Leiterbahnen der Umverdrahtungslage der ersten Bauteilanordnung elektrisch leitfähig verbunden sein. Der zweite Zwischenraum kann hierbei teilweise durch die weitere elektronische Komponente und teilweise durch die Umverdrahtungslage der ersten Bauteilanordnung begrenzt werden. Bei der Herstellung eines derartigen Packages wird typischerweise zunächst die weitere elektronische Komponente auf der Rückseite der ersten Bauteilanordnung angeordnet. Anschließend wird die dritte Bauteilanordnung wie oben beschrieben angeordnet und ein Füllmaterial wird in den zweiten Zwischenraum eingebracht beziehungsweise der zweite Zwischenraum wird mit der Vergussmasse vergossen. Indem die Umverdrahtungslage der ersten Bauteilanordnung auf ihrer Vorder- und Rückseite mit elektronischen Komponenten bestückt ist, kann eine besonders flache Bauform des Packages erreicht werden.

Die dritte und/oder die vierte Bauteilanordnung kann wie die oben beschriebene erste und/oder zweite Bauteilanordnung ausgebildet sein. Hinsichtlich des Einbringens von Füllmaterial in den zweiten Zwischenraum beziehungsweise des Vergießens des zweiten Zwischenraums und dem dafür verwendeten Füllmaterial beziehungsweise der dafür verwendeten Vergussmasse gilt das oben mit Bezug zum Einbringen von Füllmaterial in den Zwischenraum zwischen der ersten und der zweiten Bauteilanordnung beziehungsweise zum Vergießen des Zwischenraums zwischen der ersten und der zweiten Bauteilanordnung beschriebene entsprechend. Die Umverdrahtungslagen der ersten und der zweiten Bauteilanordnungen sind in typischen Ausführungen parallel zu einander ausgerichtet. Gegebenenfalls können auch die Umverdrahtungslagen der dritten und der vierten Bauteilanordnungen im Wesentlichen parallel zueinander und/oder parallel zu der Umverdrahtungslage der ersten beziehungsweise zweiten Bauteilanordnung angeordnet sein.

Die oben und unten mit Bezug zu dem Verfahren zur Herstellung des Packages beschriebenen Merkmale lassen sich auf das Package übertragen und umgekehrt.

Ausführungsbeispiele werden nachfolgend anhand der Abbildungen beschrieben. Es zeigen
- Fign. 1(a) bis (c): schematische Ansichten verschiedener Schritte während der Herstellung einer ersten Bauteilanordnung,
- Fig. 2: eine schematische Ansicht einer zweiten Bauteilanordnung,
- Fign. 3(a) bis (d): schematische Ansichten verschiedener Schritte während der Herstellung eines Packages,
- Fig. 4: eine schematische Ansicht eines Packages gemäß einer weiteren Ausführung,
- Fign. 5(a) bis (c): schematische Ansichten verschiedener Schritte während der Herstellung eines Packages gemäß einer weiteren Ausführung und
- Fig. 6: eine schematische Ansicht eines Packages gemäß einer weiteren Ausführung.

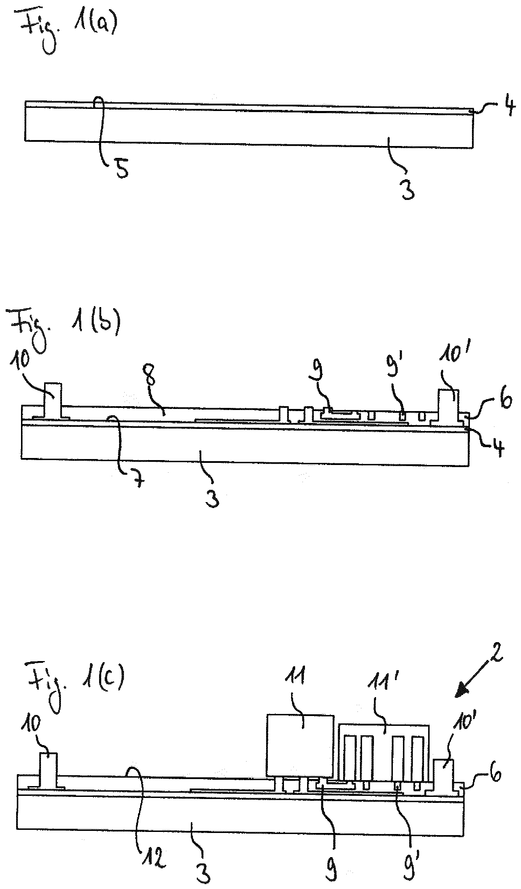

Figur 1(a) veranschaulicht einen ersten Verfahrensschritt zur Herstellung eines Packages 1, das ein dreidimensionales Fan-Out-Wafer-Level-Package ist. Das Package 1 umfasst eine erste Bauteilanordnung 2, zu deren Herstellung zunächst ein flächiger Substratträger 3, beispielsweise ein Glas- oder Siliziumträger, bereitgestellt wird. In einem weiteren Schritt wird eine Release-Schicht 4 aus Kunststoff auf einer Vorderseite 5 des Substratträgers 3 durch einen Spin-On-Prozess aufgebracht, so dass die Release-Schicht 4 die Vorderseite 5 des Substratträgers 3 vollständig bedeckt.

In einem nachfolgenden Schritt wird eine Umverdrahtungslage 6 auf einer Vorderseite 7 der Release-Schicht 4 hergestellt, wie in Fig. 1(b) gezeigt ist.

Wiederkehrende Merkmale sind in dieser und in den nachfolgenden Abbildungen mit den gleichen Bezugszeichen versehen. Die Umverdrahtungslage 6 wird durch schichtweises und strukturiertes Aufbringen von Metallisierungen und von isolierendem Material 8, beispielsweise einem Polymer, hergestellt. Hierbei können beispielsweise bekannte Lithographie-Verfahren zum Einsatz kommen. Die Metallisierungen bilden anschließend Leiterbahnen, von denen zwei beispielhaft mit den Bezugszeichen 9 und 9' versehen sind.

Außerdem werden in dem gezeigten Beispiel zwei als Mikrosäulen ausgeführte Durchkontaktierungselemente 10, 10' hergestellt. In anderen Ausführungen können die Durchkontaktierungselemente beispielsweise als Lotkugeln ausgeführt sein. Die Durchkontaktierungselemente 10, 10' sind aus einem Metall, beispielsweise aus Kupfer, gefertigt und sind mit zumindest einigen der Leiterbahnen 9, 9' elektrisch leitfähig verbunden.

Anschließend werden elektronische Komponenten 11, 11' auf einer Vorderseite 12 der Umverdrahtungslage 6 angeordnet und elektrisch mit zumindest einigen der Leiterbahnen 9, 9' verbunden. Die elektronischen Komponenten 11, 11' können verschiedenartige Bauelemente, wie beispielsweise RF-Chips, Logik-Chips oder High-Q-RF-Spulen, sein oder enthalten. Eine Vorderseite der auf diese Weise hergestellten ersten Bauteilanordnung 2 wird bereichsweise durch die Vorderseite 12 der Umverdrahtungslage 6, durch die Durchkontaktierungselemente 10, 10' und durch die elektronischen Komponenten 11, 11' gebildet.

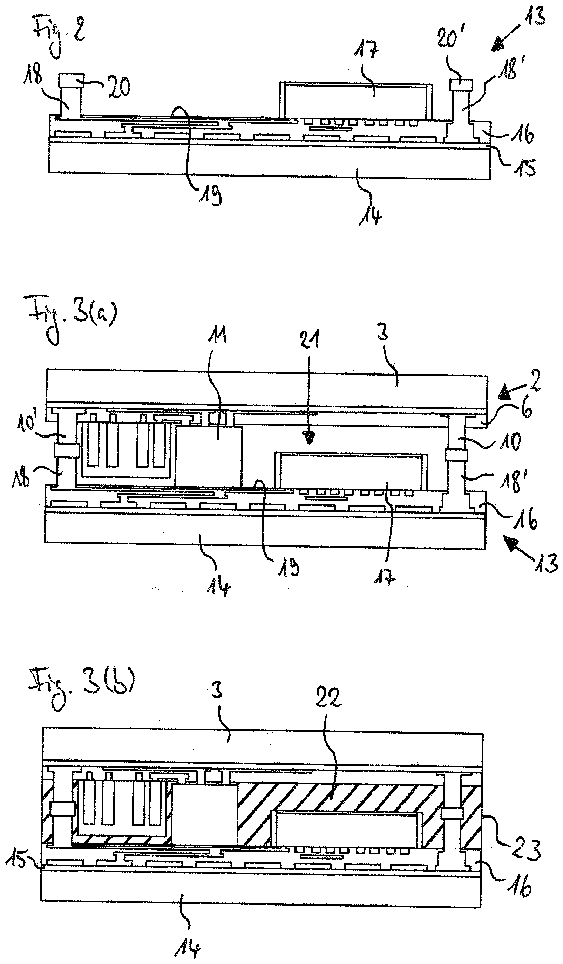

Anschließend wird eine zweite Bauteilanordnung 13 bereitgestellt, wie in Fig. 2 gezeigt ist. Diese zweite Bauteilanordung 13 kann ebenso gemäß den mit Bezug zu Fign. 1(a) bis (c) beschriebenen Schritten hergestellt werden. Die obigen, über die erste Bauteilanordnung 2 getroffenen Aussagen gelten analog für die zweite Bauteilanordnung 13. Die zweite Bauteilanordnung 13 umfasst einen Substratträger 14, eine Release-Schicht 15, eine Umverdrahtungslage 16, eine elektronische Komponente 17 sowie zwei Durchkontaktierungselemente 18, 18'. Eine Vorderseite der zweiten Bauteilanordnung 13 wird bereichsweise durch eine Vorderseite 19 der Umverdrahtungslage 16 gebildet. Die Durchkontaktierungselemente 18, 18' weisen Spitzen aus Lotmaterial 20, 20' auf.

In einem weiteren Schritt wird die zweite Bauteilanordnung 2 wie in Fig. 3(a) dargestellt kopfüber auf der ersten Bauteilanordnung 13 angeordnet. Hierbei kommt jeweils ein Durchkontaktierungselement 10, 10' der ersten Bauteilanordnung 2 auf einem Durchkontaktierungselement 18, 18' der zweiten Bauteilanordnung 13 zu liegen. Auf diese Weise wird ein Zwischenraum 21 zwischen den Bauteilanordnungen 2, 13 ausgebildet. Die Durchkontaktierungselemente 10, 10', 18, 18' werden nachfolgend paarweise verlötet, so dass eine elektrisch leitfähige Verbindung zwischen den Umverdrahtungslagen 6, 16 hergestellt wird.

Die Bauteilanordnungen 2, 13 sind derart ineinander verschachtelt angeordnet, dass die elektronischen Komponenten 11, 11', 17 in vertikaler Richtung einen überlapp aufweisen. Zudem kommt eine der elektronischen Komponenten 11 der ersten Bauteilanordnung 2 auf der Vorderseite 19 der Umverdrahtungslage 16 der zweiten Bauteilanordnung 13 zu liegen. Auf diese Weise wird ein wärmeleitender Kontakt zwischen dieser elektronischen Komponente 11 der ersten Bauteilanordnung 2 und der Umverdrahtungslage 16 der zweiten Bauteilanordnung 13 erzeugt.

Es kann vorgesehen sein, dass der Zwischenraum 21 vor dem Anordnen der Bauteilanordnungen 2, 13 zueinander oder anschließend mit einem elektrisch isolierenden Füllmaterial, beispielsweise einer Kunststofffolie oder einem Kunststoffschaum, ausgefüllt wird.

In dem in den Abbildungen gezeigten Ausführungsbeispiel wird der Zwischenraum 21 nach dem Anordnen der Bauteilanordnungen 2, 13 zueinander vollständig verfüllt, indem eine als Mold-Masse verwendete Vergussmasse 22 unter Druck und erhöhter Temperatur von einer Seite 23 her in den Zwischenraum 21 eingebracht wird. Die Vergussmasse 22 ist in Fig. 3(b) schraffiert dargestellt und enthält typischerweise ein elektrisch isolierendes Kunststoffmaterial wie beispielsweise Epoxid.

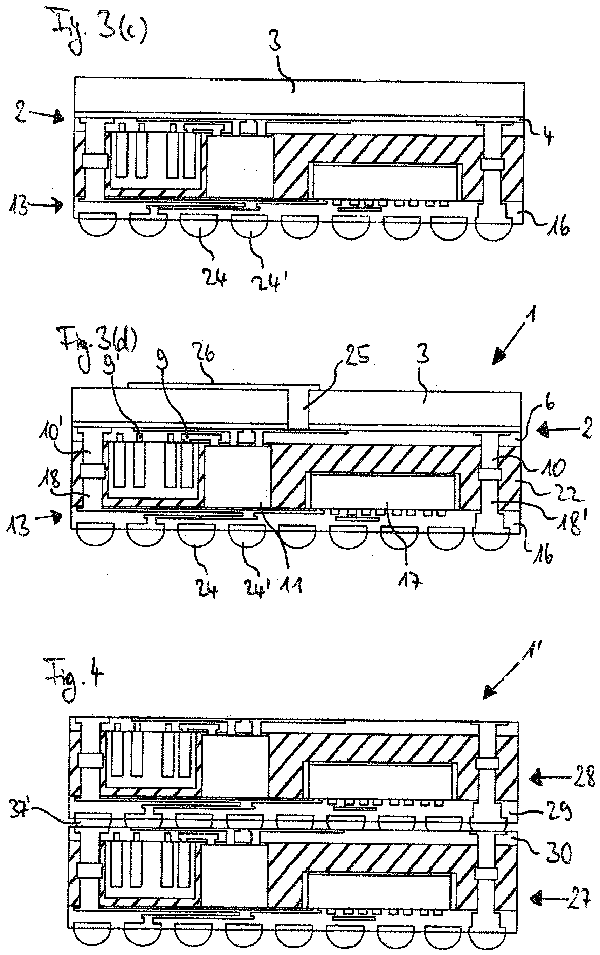

Nachfolgend werden der Substratträger 14 und die Release-Schicht 15 von der Rückseite der Umverdrahtungslage 16 der zweiten Bauteilanordnung 13 abgelöst, so dass die Rückseite der Umverdrahtungslage 16 zugänglich ist. In einem weiteren Schritt werden Lotbälle, von denen zwei beispielhaft mit den Bezugszeichen 24 und 24' versehen sind, auf der Rückseite der Umverdrahtungslage 16 angeordnet, wie Fig. 3(c) schematisch zeigt. Die Lotbälle 24, 24' sind jeweils mit zumindest einer der Leiterbahnen der Umverdrahtungslage 16 der zweiten Bauteilanordnung 13 elektrisch leitend verbunden.

Es kann in einigen Ausführungen vorgesehen sein, dass zumindest einer der Substratträger als Bestandteil des fertig hergestellten Packages, d.h. des System-In-Package, verbleibt. In dem in Fig. 3(d) dargestellten Beispiel verbleibt der Substratträger 3 auf der Umverdrahtungslage 6 der ersten Bauteilanordnung 2. Zusätzlich wird in den Substratträger 3 ein Via 25, beispielsweise ein TSV, eingebracht, um eine elektrische Verbindung zwischen Leiterbahnen 9, 9' der Umverdrahtungslage 6 und einem auf dem Substratträger 3 angeordneten Kontakt-Pad 26 herzustellen. In weiteren Schritten kann das Package 1 beispielsweise durch Sägen vereinzelt werden, so dass das Package 1 in eine Vielzahl von vereinzelten Strukturen zerfällt.

In Fig. 4 ist eine schematische Ansicht eines Packages 1' gemäß einer weiteren Ausführung gezeigt. Dieses Package 1' umfasst zwei wie oben beschriebene Packages, die hier mit den Bezugszeichen 27 und 28 versehen sind. Die Packages 27, 28 weisen weder Substratträger noch Release-Schichten auf und sind übereinander gestapelt angeordnet. Über Lotbälle, von denen einer beispielhaft mit dem Bezugszeichen 37' versehen ist, ist eine untere Umverdrahtungslage 29 des oberen Packages 28 mit einer oberen Umverdrahtungslage 30 des unteren Packages 27 verbunden.

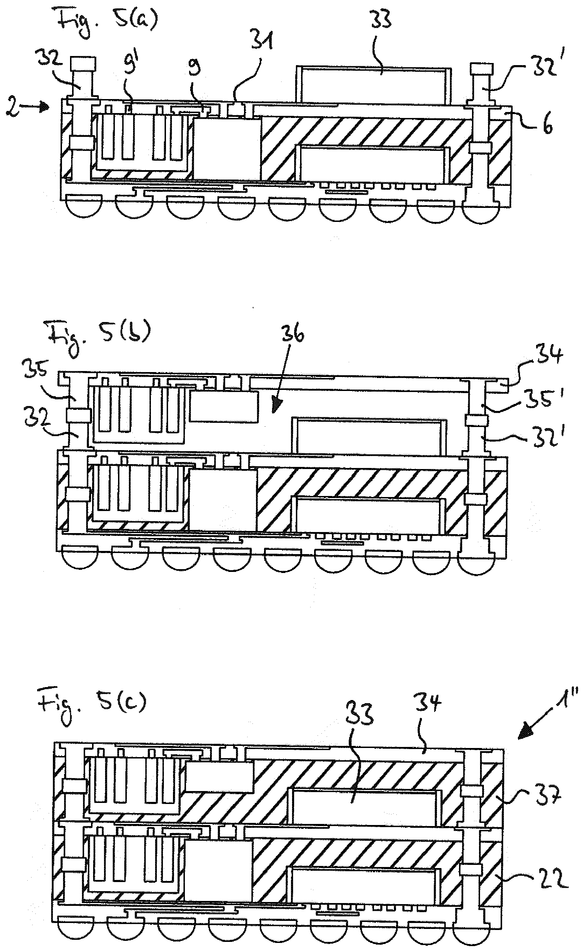

Fign. 5(a) bis (c) zeigen schematische Ansichten verschiedener Schritte während der Herstellung eines Packages 1" gemäß einer weiteren Ausführung. Zunächst kann für die Herstellung des Packages 1" wie oben bis zur Fig. 3(c) beschrieben vorgegangen werden. Anschließend können der Substratträger 3 und die Release-Schicht 4 entfernt werden, so dass eine Rückseite 31 der Umverdrahtungslage 6 der ersten Bauteilanordnung 2 freiliegt.

Anschließend können weitere Durchkontaktierungselemente 32, 32' und eine weitere elektronische Komponente 33 auf der Rückseite 31 der Umverdrahtungslage 6 der ersten Bauteilanordnung 2 angeordnet und mit Leiterbahnen 9, 9' der Umverdrahtungslage 6 der ersten Bauteilanordnung 2 verbunden werden.

Daraufhin kann eine dritte Bauteilanordnung 34, die im Wesentlichen baugleich mit der ersten Bauteilanordnung 34 ausgebildet sein kann, mit Durchkontaktierungselementen 35, 35'der dritten Bauteilanordnung auf den weiteren Durchkontaktierungselementen 32, 32' angeordnet werden, so dass ein zweiter Zwischenraum 36 ausgebildet wird, wie in Fig. 5(b) gezeigt ist. Die Durchkontaktierungselemente 32, 32', 35, 35' können nachfolgend paarweise verlötet werden.

In einem weiteren Schritt kann der zweite Zwischenraum 36 wie schon vorher der erste Zwischenraum 21 mit einer Vergussmasse 37 verfüllt werden, wie Fig. 5(c) zeigt.

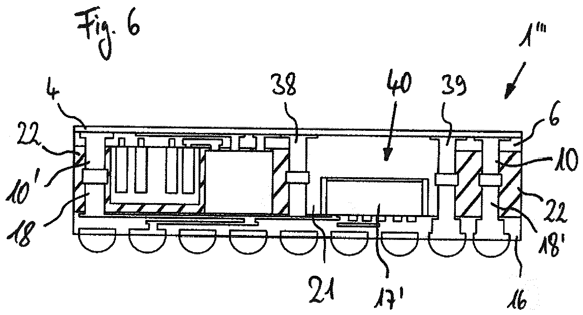

Fig. 6 zeigt ein Package 1'" gemäß einer weiteren Ausführung. Dieses Package 1'" unterscheidet sich von dem mit Bezug zu Fig. 3(d) beschriebenen Package 1 dadurch, dass Barriereelemente 38, 39 vorgesehen sind. Die Barriereelemente 38, 39 sind wie die oben beschriebenen Durchkontaktierungselemente ausgebildet und umgeben einen Teilbereich 40 des Zwischenraums 21 so, dass der Teilbereich 40 fluiddicht abgeschlossen ist. In dem Teilbereich 40 ist eine als Sensor mit empfindlicher Oberfläche ausgebildete elektronische Komponente 17' angeordnet. Durch die fluiddichten Barriereelemente 38, 39 dringt die Vergussmasse 22 beim Verfüllen nicht in den Teilbereich 40 ein. Auf diese Weise wird in dem Teilbereich 40 eine Aussparung in der Vergussmasse 22 erzeugt.

Es ist in typischen Ausführungen vorgesehen, dass sich die Barriereelemente sich zwischen der ersten Bauteilanordnung und der zweiten Bauteilanordnung erstrecken und einen Teilbereich des Zwischenraums derart umschließen, dass der Zwischenraum nicht vollständig mit dem Füllmaterial ausgefüllt wird. Die Barriereelemente könnten mehrteilig sein oder auch durch ein einstückiges Elemente gebildet werden. Der Teilbereich, in den kein Füllmaterial eindringt, erstreckt sich dann typischerweise ebenfalls von der ersten Bauteilanordnung bis zur zweiten Bauteilanordnung. Zudem können die Barriereelemente zumindest eine der Leiterbahnen der Umverdrahtungslage der ersten Bauteilanordnung und zumindest eine der Leiterbahnen der Umverdrahtungslage der zweiten Bauteilanordnung elektrisch leitfähig miteinander verbinden. Außerdem können die Barriereelemente starr und beispielsweise als Micropillars ausgebildet sein. In derartigen Ausführung erfüllen die Barriereelemente gleichzeitig zumindest zwei oder sogar drei der folgenden Funktionen: Erstens können die Barriereelemente dafür sorgen, dass Teilbereiche des Zwischenraums frei von Füllmaterial bleiben. Zweitens können die Barriereelemente gewährleisten, dass beim Anordnen der Bauteilanordnungen zueinander bereits eine gewünschte endgültige Höhe des Zwischenraums erreicht wird. Drittens können durch die Barriereelemente einen elektrischen Kontakt zwischen den Umverdrahtungslagen der verschiedenen Bauteilanordnungen erzeugen.

Lediglich in den Ausführungsbeispielen offenbarte Merkmale der verschiedenen Ausführungsformen können miteinander kombiniert und einzeln beansprucht werden.

## Patentansprüche

1. Verfahren zur Herstellung eines Packages (1, 1', 1"), umfassend:
- Bereitstellen einer ersten Bauteilanordnung (2) und einer zweiten Bauteilanordnung (13), wobei die erste Bauteilanordnung (2) und die zweite Bauteilanordnung (13) jeweils eine flächige Umverdrahtungslage (6, 16) und jeweils zumindest eine auf einer in Richtung einer Vorderseite der Bauteilanordnung (2, 13) weisenden Seite der Umverdrahtungslage (6, 16) angeordnete elektronische Komponente (11, 11', 17) aufweisen, wobei die Umverdrahtungslage (6, 16) elektrisch isolierendes Material (8) und Leiterbahnen (9, 9') aufweist und wobei zumindest eine der Leiterbahnen (9, 9') der Umverdrahtungslage (6, 16) mit der elektronischen Komponente (11, 11', 17) elektrisch leitend verbunden ist, und **gekennzeichnet durch** folgende Schritte:
- Anordnen der Bauteilanordnungen (2, 13) zueinander, derart dass die Vorderseiten der Bauteilanordnungen (2, 13) einander zugewandt sind und dass ein durch die Bauteilanordnungen (2, 13) begrenzter Zwischenraum (21) zwischen den Umverdrahtungslagen (6, 16) ausgebildet wird, und
- Einbringen eines Füllmaterials in den Zwischenraum (21).

2. Verfahren nach Anspruch 1, **dadurch gekennzeichnet, dass** Barriereelemente (38, 39) vorgesehen sind, die sich zwischen der ersten Bauteilanordnung (2) und der zweiten Bauteilanordnung (13) erstrecken und einen Teilbereich des Zwischenraums (21) derart umschließen, dass der Zwischenraum (21) nicht vollständig mit dem Füllmaterial ausgefüllt wird.

3. Verfahren nach Anspruch 2, **dadurch gekennzeichnet, dass** die Barriereelemente (38, 39) zumindest eine der Leiterbahnen der Umverdrahtungslage (6) der ersten Bauteilanordnung (2) und zumindest eine der Leiterbahnen der Umverdrahtungslage (16) der zweiten Bauteilanordnung (13) elektrisch leitfähig miteinander verbinden.

4. Verfahren nach einem der Ansprüche 1 bis 3, **dadurch gekennzeichnet, dass** das Einbringen des Füllmaterials in den Zwischenraum umfasst:
- Vergießen des Zwischenraums (21) zwischen der ersten Bauteilanordnung (2) und der zweiten Bauteilanordnung (13) mit einer Vergussmasse (22).

5. Verfahren nach einem der Ansprüche 1 bis 4, **dadurch gekennzeichnet, dass** die erste Bauteilanordnung (2) auf der in Richtung der Vorderseite der Bauteilanordnung (2) weisenden Seite der Umverdrahtungslage (6) zumindest ein mit zumindest einer der Leiterbahnen (9, 9') elektrisch leitfähig verbundenes Durchkontaktierungselement (10, 10') aufweist, und **gekennzeichnet durch** den Schritt
- Elektrisch leitfähiges Verbinden des zumindest einen Durchkontaktierungselements (10, 10') mit zumindest einer der Leiterbahnen der Umverdrahtungslage (16) der zweiten Bauteilanordnung (13) nach dem Anordnen oder während des Anordnens der Bauteilanordnungen (2, 13) zueinander.

6. Verfahren nach Anspruch 5, **dadurch gekennzeichnet, dass** die zweite Bauteilanordnung (13) zumindest ein mit zumindest einer der Leiterbahnen der Umverdrahtungslage (16) der zweiten Bauteilanordnung (13) elektrisch leitfähig verbundenes Durchkontaktierungselement (18, 18') aufweist, wobei die Bauteilanordnungen (2, 13) derart zueinander angeordnet werden, dass ein Bereich des Durchkontaktierungselements (10, 10') der ersten Bauteilanordnung (2) auf einem Bereich des Durchkontaktierungselements (18, 18') der zweiten Bauteilanordnung (13) zu liegen kommt, und wobei beim elektrisch leitfähigen Verbinden des Durchkontaktierungselements (10, 10') der ersten Bauteilanordnung (2) mit der Leiterbahn der Umverdrahtungslage (16) der zweiten Bauteilanordnung (13) das Durchkontaktierungselement (10, 10') der ersten Bauteilanordnung (2) mit dem Durchkontaktierungselement (18, 18') der zweiten Bauteilanordnung (13) elektrisch leitfähig verbunden wird.

7. Verfahren nach Anspruch 6, **dadurch gekennzeichnet, dass** das Durchkontaktierungselement (10, 10') der ersten Bauteilanordnung (2) und das Durchkontaktierungselement (18, 18') der zweiten Bauteilanordnung (13) beim Anordnen der Bauteilanordnungen (2, 13) zueinander zumindest bereichsweise fest und/oder steif sind.

8. Verfahren nach einem der Ansprüche 5 bis 7, **dadurch gekennzeichnet, dass** das Durchkontaktierungselement (10, 10', 18, 18') der ersten Bauteilanordnung (2) zumindest bereichsweise als Micropillar ausgebildet ist.

9. Verfahren nach einem der Ansprüche 1 bis 8, **dadurch gekennzeichnet, dass** beim Anordnen der Bauteilanordnungen (2, 13) zueinander eine Vorderseite der elektronischen Komponente (11) der ersten Bauteilanordnung (2) an der zweiten Bauteilanordnung (13) zum Anliegen kommt.

10. Verfahren nach Anspruch 9, **dadurch gekennzeichnet, dass** die Vorderseite der elektronischen Komponente (11) der ersten Bauteilanordnung (2) an einer Vorderseite der Umverdrahtungslage (16) der zweiten Bauteilanordnung (13) zum Anliegen kommt.

11. Verfahren nach einem der Ansprüche 1 bis10, **dadurch gekennzeichnet, dass** die erste Bauteilanordnung (2) und die zweite Bauteilanordnung (13) derart zueinander angeordnet werden, dass eine parallel zur Umverdrahtungslage (6, 16) der ersten und/oder der zweiten Bauteilanordnung (2, 13) verlaufende Ebene sowohl die elektronische Komponente (11, 11') der ersten Bauteilanordnung (2) als auch die elektronische Komponente (17) der zweiten Bauteilanordnung (13) schneidet und/oder
**gekennzeichnet durch** den Schritt:
- Herstellen von elektrisch mit zumindest einer der Leiterbahnen (9, 9') verbundenen Lötkontakten (24, 24') auf einer von der Vorderseite der ersten und/oder der zweiten Bauteilanordnung (2, 13) abgewandten Seite der Umverdrahtungslage (6, 16) der ersten beziehungsweise der zweiten Bauteilanordnung (2, 13) zur Montage des Packages (1, 1', 1") auf einer Leiterplatte.

12. Package (1, 1', 1") mit einer ersten Bauteilanordnung (2) und einer zweiten Bauteilanordnung (13), wobei die erste Bauteilanordnung (2) und die zweite Bauteilanordnung (13) jeweils eine flächige Umverdrahtungslage (6, 16) und jeweils zumindest eine auf einer in Richtung einer Vorderseite der Bauteilanordnung (2, 13) weisenden Seite der Umverdrahtungslage (6, 16) angeordnete elektronische Komponente (11, 11', 17) aufweisen, wobei die Umverdrahtungslage (6, 16) elektrisch isolierendes Material (8) und Leiterbahnen (9, 9') aufweist und wobei zumindest eine der Leiterbahnen (9, 9') der Umverdrahtungslage (6, 16) mit der elektronischen Komponente (11, 11', 17) elektrisch leitend verbunden ist, wobei die Bauteilanordnungen (2, 13) derart zueinander angeordnet sind, dass die Vorderseiten der Bauteilanordnungen (2, 13) einander zugewandt sind und dass ein durch die Bauteilanordnungen (2, 13) begrenzter Zwischenraum (21) zwischen den Umverdrahtungslagen (6, 16) ausgebildet ist, wobei in den Zwischenraum (21) zwischen der ersten Bauteilanordnung (2) und der zweiten Bauteilanordnung (13) ein Füllmaterial eingebracht ist, wobei der Zwischenraum (21) insbesondere mit einer Vergussmasse (22) vergossen ist.

13. Package (1', 1") nach Anspruch 12, **gekennzeichnet durch** eine dritte Bauteilanordnung (34), wobei die dritte Bauteilanordnung (34) eine flächige Umverdrahtungslage und zumindest eine auf einer in Richtung einer Vorderseite der dritten Bauteilanordnung (34) weisenden Seite der Umverdrahtungslage angeordnete elektronische Komponente aufweist, wobei die Umverdrahtungslage elektrisch isolierendes Material und Leiterbahnen aufweist und wobei zumindest eine der Leiterbahnen der Umverdrahtungslage mit der elektronischen Komponente elektrisch leitend verbunden ist, wobei die dritte Bauteilanordnung (34) derart angeordnet ist, dass die Vorderseite der dritten Bauteilanordnung (34) einer Rückseite der ersten Bauteilanordnung (2) zugewandt ist und dass ein zwischen der dritten Bauteilanordnung (34) und der ersten Bauteilanordnung (2) ausgebildeter und teilweise durch die dritte Bauteilanordnung (34) begrenzter zweiter Zwischenraum (36) ausgebildet ist, wobei der zweite Zwischenraum (36) ein Füllmaterial enthält oder mit einer Vergussmasse (37) vergossen ist.

14. Package (1') nach Anspruch 13, **gekennzeichnet durch** eine vierte Bauteilanordnung, wobei die vierte Bauteilanordnung eine flächige Umverdrahtungslage und zumindest eine auf einer in Richtung einer Vorderseite der vierten Bauteilanordnung weisenden Seite der Umverdrahtungslage angeordnete elektronische Komponente aufweist, wobei die Umverdrahtungslage elektrisch isolierendes Material und Leiterbahnen aufweist und wobei zumindest eine der Leiterbahnen der Umverdrahtungslage mit der elektronischen Komponente elektrisch leitend verbunden ist, wobei die vierte Bauteilanordnung derart zwischen der ersten Bauteilanordnung und der dritten Bauteilanordnung angeordnet ist, dass die Vorderseite der vierten Bauteilanordnung der dritten Bauteilanordnung zugewandt und von der ersten Bauteilanordnung (2) abgewandt ist, wobei zumindest eine der Leiterbahnen der vierten Bauteilanordnung mit zumindest einer der Leiterbahnen der ersten Bauteilanordnung (2) elektrisch leitend verbunden ist
oder
**gekennzeichnet durch** eine weitere elektronische Komponente (33), wobei die weitere elektronische Komponente (33) auf der Rückseite der ersten Bauteilanordnung (2) angeordnet und mit zumindest einer der Leiterbahnen der Umverdrahtungslage der ersten Bauteilanordnung (2) elektrisch leitfähig verbunden ist.

15. Package (1") nach einem der vorangehenden Ansprüche, **dadurch gekennzeichnet, dass** dieses stapelbar ist und dass durch die elektronischen Komponenten eine dreidimensionale Package-Struktur ausgebildet wird.
